# EUROPEAN PATENT APPLICATION

(11) **EP 0 525 576 A1**
(43) Date of publication of application: **03.02.1993**
(21) Application number: 92112396.4
(22) Date of filing: 20.07.1992
(51) Int. Cl.: G06F 15/60

(54) **Design flow methodology for an integrated circuit**

(30) Priority: 26.07.1991 US 736554
(71) Applicant: MOTOROLA, INC., Schaumburg, IL 60196 (US)
(72) Inventor: Tou, Jarvis, Gilbert, Arizona 85234 (US); Gee, Perry, Chandler, Arizona 85224 (US)
(74) Representative: Dunlop, Hugh Christopher

(57) **Abstract**

A design flow methodology for developing an integrated circuit is provided. An ASIC developer creates generator function tools which allow an end-user to spontaneously create additional desired functions that are not already in the existing library without returning to the ASIC developer. As a result, only required functions are stored in the library thereby minimizing library data.

Moreover, the end-user has the capability to characterize the functions at a plurality of different hierarchical levels for quick a simulation or a detailed simulation. As a result, the cycle time for an integrated circuit design is substantially reduced, while quality is improved.

## Description

### Background of the Invention

This invention relates to integrated circuits, for example, a design flow methodology for an integrated circuit.

Present standard application specific integrated circuit (ASIC) design methodologies entail the ASIC developer to generate and pre-characterize all library elements before the software package is released to an end-user (customer). That is, the entire library, which includes data such as symbols, functional models, timing parameters, verification data, and layout information of a finite set of elements, is released to the end-user regardless of whether it is actually being used by the end-user in a design. As a result, this method can be time consuming and error prone as well as wasteful since the ASIC developer must create various library functions that may never be used by the end-user.

Hence, there exists a need for an improved design flow methodology for an application specific integrated circuit design that abates the need for the ASIC developer to create all library functions before release to an end-user.

### Summary of the Invention

Briefly, there is provided a method created by an ASIC developer to allow an end-user to design an integrated circuit, the method comprising the steps of developing generator tools by the ASIC developer, said generator tools performing layout, characterization and development of models, symbols and abstractions for a plurality of functions; and generating functions on demand by the end-user by utilizing said generator tools.

The present invention will be better understood from the following detailed description taken in conjunction with the accompanying drawings.

### Brief Description of the Drawings

FIG. 1 is a flowchart illustrating a prior art design flow methodology for developing applications specific integrated circuits; and
FIG. 2 is a flowchart illustrating a design flow methodology for developing an application specific integrated circuit in accordance with the present invention.

### Detailed Description of the Drawings

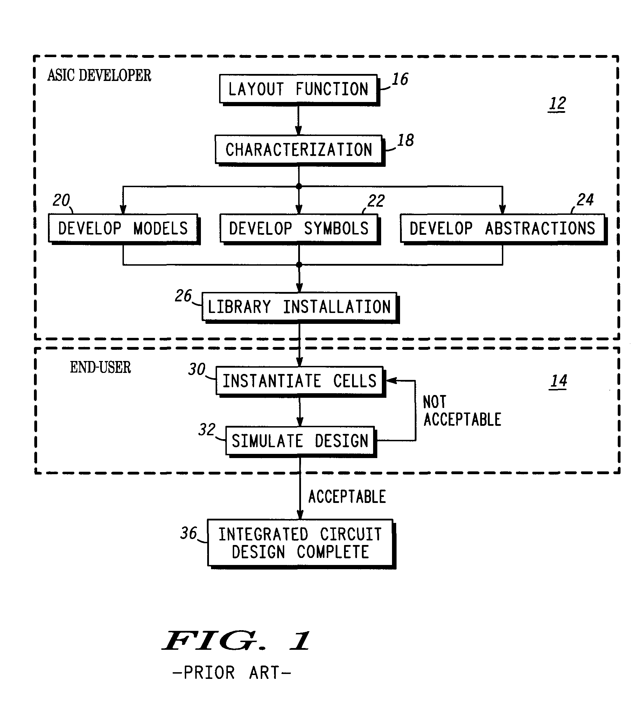

Referring to FIG. 1, a flowchart illustrating a prior art design flow methodology for developing an application specific integrated circuit (ASIC) is shown comprising ASIC developer block 12 and end-user block 14. ASIC developer block 12 includes steps which are performed by the ASIC developer. On the other hand, end-user block 14 includes steps that are performed by the end-user or customer who wishes to produce an integrated circuit design.

Referring to ASIC developer block 12, the ASIC developer begins by laying out the function as illustrated by box 16. Layout of the function involves utilizing metal layers to connect various basic cells to perform a desired function. In essence, a custom layout is designed for each particular function.

Next, based on the function layout, a complete characterization of the function is performed as illustrated by box 18. Characterization of the function involves intrinsic delays and setup and hold times characterizations which are based on parameters such as output load and input edge rates.

From the characterization of the function and the way that the function should operate, models of the function are developed as illustrated by box 20. A model of the function via a model created from functional modeling language, are functional descriptions of how the function should operate. In particular, a model would include information which would specify the logic states of the outputs of the function for a given set of input logic states. For example, for a model of a typical inverter, if the input of the inverter is a logic zero, the model would specify that the output of the inverter should be a logic one.

In addition to developing models, symbols are also developed as illustrated by box 22. In particular, symbols are boxes having inputs and outputs that appear on the screen thereby allowing an integrated circuit designer to instantiate and symbolically wire-up a desired circuit.

Furthermore, in addition to developing models and symbols, abstractions are developed as illustrated by box 24. Abstractions typically include other types of views of the function. For example, in a routing abstraction, a router does not need to see the internal layout of the function, but rather the router needs to see a boundary identifying the size and location of the function as well as the location of the input and output ports. Other abstractions may include an automatic test pattern generation or a logic synthesis abstraction.

Once the models, symbols and abstractions are developed, all this information for each particular function is then installed in a library as illustrated by box 26. After qualifying the library for accuracy and quality, this entire software package is ready for release to an end-user.

Upon receiving the software package and installing it on a suitable computer or workstation, the end-user is ready to begin an integrated circuit design wherein the end-user may utilize all the functions that are installed in the library by the ASIC developer.

Referring to end-user block 14, the end-user begins by instantiating cells as illustrated by box 30. By instantiating cells, the end-user utilizes the symbols which reside in the library to create a specific circuit design.

The design is then simulated as illustrated by box 32. The design is simulated by a simulator that utilizes the models and various timing abstractions that were installed in the library by the ASIC developer. If the results of the simulation are not acceptable, the end-user may instantiate different cells from the library and perform additional simulations. Once the simulation results are acceptable, the integrated circuit design is complete as illustrated by box 36.

It is understood that design simulation may be performed via third party tools.

The design flow methodology illustrated in FIG. 1 requires a very extensive test that must be performed by the ASIC developer after the models, symbols and abstractions are installed in the library as aforementioned. That is, before the software package is released to an end-user, the accuracy and quality of the data installed in the library must be fully verified. Further, this involves verifying a large amount of data and can be very time consuming and error prone. However, a disadvantage of the design flow methodology of FIG. 1 is that some of the functions installed in the library may never be used by an end-user.

Moreover, the design flow methodology illustrated in FIG. 1 has at least another disadvantage. Suppose for example, the end-user desires a cell or a function that has not been previous installed in the library by the ASIC developer. Therefore, a desire for a new function involves the end-user going back to the ASIC developer and requesting this additional function. The ASIC developer must then perform all the aforedescribed steps illustrated in box 12 all over again for this additional function. This alone can be quite time consuming for complex functions.

In addition, once the models, symbols and abstractions for this additional function are developed, they are appended to the library and the entire library must again be verified for accuracy and quality before release back to the end-user. This, of course, is very labor intensive and time consuming as aforementioned. Moreover, most of the verifying is redundant with respect to the previous verification.

Thus, the design flow methodology illustrated in FIG. 1 is quite time consuming for both the ASIC developer and the end-user when additional cells or functions are desired by the end-user. This can substantially increase the cycle time for developing an integrated circuit design.

It is a goal of the present invention to develop a design flow methodology wherein the ASIC developer creates generator tools that allow the end-user to generate desired functional blocks at the time of need. In other words, functional blocks are generated and characterized on demand by the end-user. Thus, by creating all necessary data on the end-user demand, the ASIC developer does not have to release such comprehensive library data and information. Further, if the end-user desires a new function which is not already in the library, the end-user can create this new function without returning back to the ASIC developer. As a result, cycle time is substantially improved.

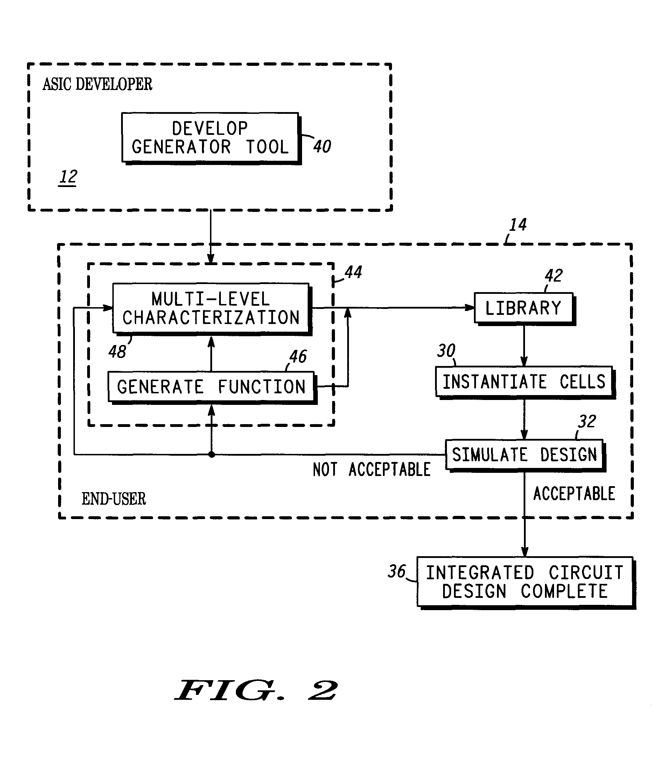

Referring to FIG. 2, a flowchart illustrating a design flow methodology for developing an integrated circuit is shown. It is understood that blocks and boxes shown in FIG. 2 which are identical to the blocks and boxes shown in FIG. 1 are identified by the same reference numbers.

The ASIC developer of FIG. 2 develops generator tools as illustrated by box 40. The generator tools include the necessary software to allow an end-user to generate a particular function such as a RAM generator or a multiplier generator. That is, the generator tools automatically performs function layout, function characterization, and develops models, symbols and abstractions for a plurality of functions. Thus, the software for boxes 16, 18, 20, 22 and 24 shown in FIG. 1 are automated via develop generator tool 40 of FIG. 2.

Once the generator tool is developed, it must be verified for accuracy and quality. However, an advantage of the present invention is that the generator tool must be verified for accuracy and quality only once, regardless of any additional changes or modifications that are desired by the end-user.

Once the generator tool is verified, it is then ready to be released to an end-user.

Referring to end-user block 12 of FIG. 2, the end-user first begins with a basic library as illustrated in box 42. The library typically contains various basic functions that have previously been developed by the ASIC developer which are common in most designs, for example, an inverter.

The end-user then instantiates cells from the library to create a specific circuit design and that design is then simulated as aforedescribed and as illustrated by boxes 30 and 32.

If the simulation of the design is not acceptable, the end-user possesses the ability to utilize the generator tools which have been developed by the ASIC developer to generate additional desired functions as illustrated by box 46. Furthermore, the end-user also has the capability to perform multi-level characterization as illustrated by block 48 and described in detail hereinafter. It is understood that block 44 includes the software created by the ASIC developer as aforedescribed for box 40. In particular, box 46 includes layout function and development of models, symbols and abstractions. Further, box 48 includes function characterization for a plurality of levels of accuracy.

As an example, suppose that a NAND gate generator has been originally developed by the ASIC developer and is included as one of the generator tools of box 40. This NAND gate generator tool will be capable of generating any size NAND gate desired by the end-user such as a two input NAND gate, a three input NAND gate, or a ten input NAND gate. Further, since the NAND gate generator tool has been qualified before release to the end-user, each NAND gate generated by the end-user via the NAND gate generator will be correct by construction.

Thus, if the end-user decides that a three input NAND gate is not sufficient and requires a four input NAND gate, the generate function can be readily utilized to quickly generate, at the time of need, a four input NAND gate. The results of the generate function can then be automatically stored in the library where it is then available as a function which can be utilized to create a circuit design.

In addition, the results of the generate function can also be sent to a multi-level characterization routine which essentially characterizes the function at selected predetermined levels. Multi-level characterization as illustrated in box 48 allows the end-user to choose a plurality of levels of characterization according to end-user need.

In essence, multi-level characterization takes the function that has been generated and characterizes it to a selected level thereby creating a timing file that is to be inserted into the library. Further, it is understood that multi-level characterization box 48 performs the function of the characterization of box 18 of FIG. 1 wherein box 18 characterized the function at a high level of accuracy. However, multi-level characterization box 48 is not only capable of characterizing the function at a high level of accuracy, but it can also characterize the function at lower levels of accuracy for quick simulation results.

It is understood that as characterization accuracy increases, simulation time also increases. Thus, if the end-user is beginning a design and only has a rough idea of the type of design he wishes to obtain, the end-user does not require exact simulation results to be able to narrow down the design options. As a result, the end-user may only desire quick simulation data that will adequately prove the concept of the design. Therefore, the end-user may utilize a simple table look-up and interpolation characterization.

As an example, in the beginning stages of an integrated circuit design, the end-user may not be concerned with the propagation delay of a function. Thus, the end-user utilizes a low level of function characterization such that the propagation delay of the function is 5 nanoseconds plus or minus 1 nanosecond. However, once the design is more concrete and more reliable characterization information is needed, the end-user may utilize a higher level of function characterization wherein the propagation delay is 5 nanoseconds plus or minus 0.1 nanoseconds. Thus, by using a higher level of function characterization, the reliability and trust of the simulation is increased.

In comparison with the design flow methodology illustrated in FIG. 1, the multi-level characterization as illustrated by box 48 in FIG. 2 allows the end-user to characterize the function at a plurality of levels. However, the characterization performed by the ASIC developer as aforedescribed for box 18 of FIG. 1, was done only at one level and it was a very high and accurate level. Therefore, it was time consuming for an end-user to perform a quick simulation of a design. In contrast, the present invention allows the end-user to perform quick simulation in order to reach a more concrete design in a substantially reduced time.

By now it should be apparent from the foregoing discussion that a novel design flow methodology for developing an integrated circuit has been provided. The novel method allows an end-user to spontaneously create additional desired functions that are not already in the existing library without returning to the ASIC developer. As a result, the number of functions stored in the library by the ASIC developer is substantially reduced.

Moreover, the end-user has the capability to characterize the functions at a plurality of hierarchical levels for quick a simulation or a detailed simulation. As a result, the cycle time for an integrated circuit design is substantially reduced.

While the invention has been described in conjunction with specific embodiments thereof, it is evident that many alterations, modifications and variations will be apparent to those skilled in the art in the light of the foregoing description. Accordingly, it is intended to embrace all such alterations, modifications and variations in the appended claims.

## Claims

1. A method created by an ASIC developer to allow an end-user to design an integrated circuit, the method comprising the steps of:
(a) developing generator tools by the ASIC developer, said generator tools performing layout, characterization and development of models, symbols and abstractions for a plurality of functions; and
(b) generating functions on demand by the end-user by utilizing said generator tools developed in step (a).

2. The method according to claim 1 wherein said generator tools developed in step (a) are capable of characterizing said plurality of functions at a plurality of hierarchical levels.

3. The method according to claim 1 further includes storing said functions generated by the end-user in step (b) in a library.

4. A method for developing an integrated circuit design, the method comprising the steps of:
(a) developing generator tools and a library by an ASIC developer, said generator tools performing layout, characterization, and development of models, symbols and abstractions for a first plurality of functions, said library including a second plurality of functions;
(b) verifying said generator tools and said library for accuracy and quality;
(c) releasing said generator tools and said library to an end-user;
(d) utilizing said second plurality of functions in said library by said end-user to create a design;
(e) simulating said design created in step
(d);
(f) generating functions from said first plurality of functions on demand by the end-user by utilizing said generator tools developed in step (a)
(g) storing said functions generated in step
(f) in said library thereby creating additional functions in said library;
(h) utilizing said second plurality of functions and said additional functions in said library by said end-user to create the integrated circuit design.

5. The method according to claim 6 wherein said generator tools developed in step (a) are capable of characterizing said first plurality of functions at a plurality of hierarchical levels.
